# EUROPEAN PATENT APPLICATION

(11) **EP 4 495 686 A1**
(43) Date of publication of application: **22.01.2025**
(21) Application number: 22932256.5
(22) Date of filing: 18.03.2022
(51) Int. Cl.: G03F 1/62

(54) **EUV-TRANSMISSIVE FILM PRODUCTION METHOD AND PELLICLE**

(71) Applicant: NGK Insulators, Ltd., Nagoya city, Aichi 467-8530 (JP)
(72) Inventor: KASHIWAYA Toshikatsu, Nagoya-City, Aichi 467-8530 (JP); GOURIKI Naoki, Nagoya-City, Aichi 467-8530 (JP)
(74) Representative: Müller-Boré & Partner Patentanwälte PartG mbB
(86) International application number: PCT/JP2022/012918
(87) International publication number: WO 2023/175990

(57) **Abstract**

Provided is a method for producing a high-quality EUV-transmissive film or pellicle by an efficient method that prevents the mask layer from remaining in an eave shape extending towards a cavity and thus is less likely to generate particles. This method includes the steps of: providing a substrate having a first surface and a second surface; covering, with a mask layer, the entire region of the first surface and a peripheral region other than a cavity region positioned in the center of the second surface; partially etching away the substrate exposed to the cavity region to form a cavity; etching away the mask layer covering the first surface; forming an EUV-transmissive film on the surface of the substrate on the cavity side and on the surface of the mask layer covering the second surface; and etching away the substrate from the first surface until the EUV-transmissive film is exposed to an opposite side from the cavity to form the EUV-transmissive film in the cavity region into a self-supporting film.

## Description

### TECHNICAL FIELD

The present invention relates to a method for producing an EUV-transmissive film and a pellicle.

### BACKGROUND ART

Miniaturization in the semiconductor production process has proceeded in recent years, and various improvements have been made in each step. In particular, in the photolithography step, EUV (extreme ultraviolet ray) light having a wavelength of 13.5 nm has come into use instead of conventional ArF exposure having a wavelength of 193 nm. This results in a reduction in the wavelength to 1/10 or less at one stroke, and the optical characteristics thereof have become completely different. However, there is no substance having a high transmittance to EUV light, and accordingly, a pellicle, which is a film for preventing particles from adhering to a photomask (reticle), suitable for practical use does not exist yet, for example. Thus, device manufacturers currently produce semiconductor devices without using pellicles.

Thus, a poly Si-based pellicle film is suggested. For example, Patent Literature 1 (JP6858817B) discloses a pellicle film including a core layer containing a material substantially transparent to EUV radiation, such as (poly) Si, and a cap layer containing a material that absorbs IR radiation. However, when the poly Si-based pellicle film has a thickness sufficient to retain the film strength, the EUV transmittance thereof cannot reach 90% of the target, so that the poly Si-based pellicle film cannot be practically used yet.

A carbon nanotube (CNT)-based pellicle film is also developed (e.g., Patent Literature 2 (JP2018-194840A)), and a higher EUV transmittance is expected. The CNT-based pellicle film has no durability against environment of usage of pellicle (low pressure hydrogen atmosphere). In fact, when such a pellicle film is coated with metal to impart durability, the EUV transmittance thereof is reduced, so that the transmittance at a practical level cannot be achieved.

Various methods for producing a pellicle film are suggested. For example, Non-Patent Literature 1 (Dario L. Goldfarb, "Fabrication of a full size EUV pellicle based on silicon nitride", Volume 31, Issue 12, PHOTOMASK, SPIE, 2015) discloses a method for producing a SiNx self-supporting film as a pellicle film. The basic method thereof is as follows. First, a SiNx film serving as a pellicle film is formed on both surfaces of a Si substrate (step A). Then, a reactive ion etching (RIE) mask for etching the formed SiNx is formed on only one surface (step B). A part of SiNx is removed by RIE to expose the Si substrate (step C). Both surfaces of the Si substrate are coated with amorphous Si, and then the outer shape of the Si substrate is diced (step D). Finally, the Si substrate is wet-etched using the SiNx film as a mask, to thereby form into a SiNx self-supporting film (step E).

### CITATION LIST

### PATENT LITERATURE

Patent Literature 1: JP6858817B
Patent Literature 2: JP2018-194840A

### NON-PATENT LITERATURE

Non-Patent Literature 1: Dario L. Goldfarb, "Fabrication of a full size EUV pellicle based on silicon nitride", Volume 31, Issue 12, PHOTOMASK, SPIE, 2015

### SUMMARY OF INVENTION

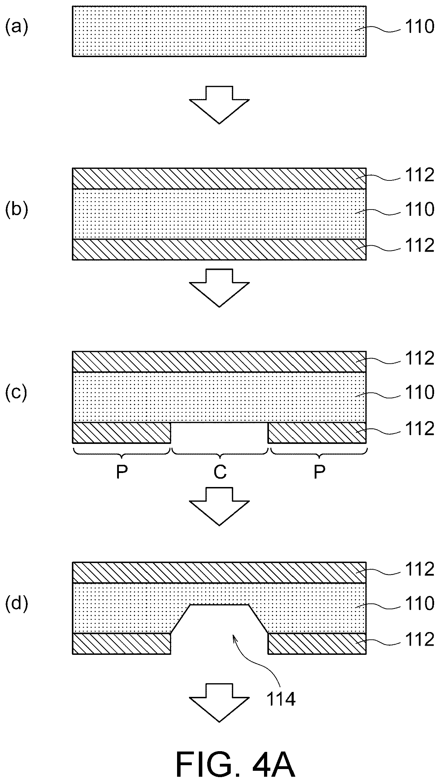

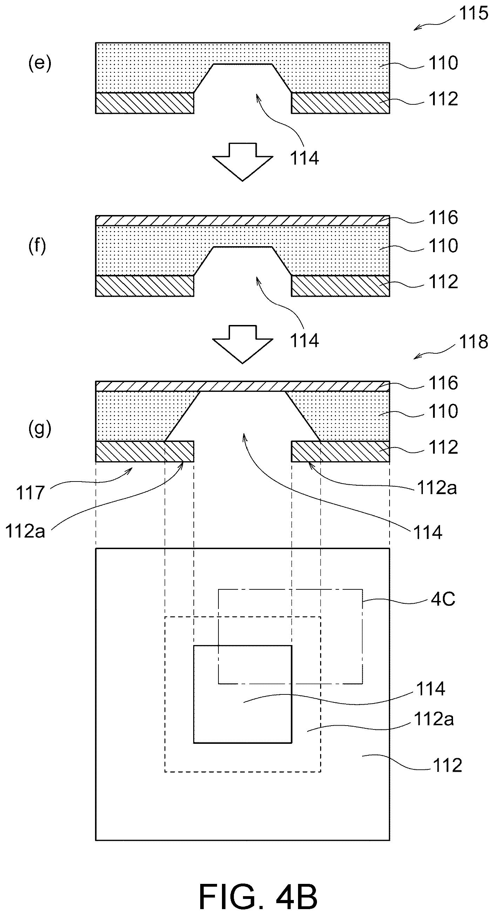

When an EUV-transmissive film is attempted to be produced as a pellicle film with reference to a conventional production method as disclosed in Non-Patent Literature 1, it is considered that the EUV-transmissive film is formed on a substrate, and then unnecessary parts of the substrate are etched away to form the EUV-transmissive film into a self-supporting film. Figures 4A and 4B illustrate an example of such a conventional production process. In this conventional process, first, a substrate 110 such as a Si wafer is provided (Figure 4A(a)). A mask layer 112 such as a SiOz layer is formed on each surface of the substrate 110. A resist is applied to one surface or both surfaces of the substrate 110, and exposure and development are carried out so that a resist hole having a predetermined size is formed on one surface, thereby forming a resist mask for etching (not shown). By etching one surface of the substrate 110, the exposed part of the mask layer 112 is etched away to form an opening corresponding to a cavity region C (Figure 4A(c)). After the resist mask is removed, the substrate 110 is etched with an etching solution such as a TMAH (tetramethyl ammonium hydroxide) solution to make the cavity region C of the substrate 110 thin to have a desired thickness to thereby form a cavity 114 (Figure 4A(d)). The mask layer 112 present on the surface on the opposite side to the cavity 114 is etched away to obtain a cavity substrate 115 (Figure 4B(e)). An EUV-transmissive film 116 is formed on the surface on the opposite side from the cavity 114 of the cavity substrate 115 (Figure 4B(f)). Finally, the substrate 110 corresponding to a part that is formed into a self-supporting film is etched away to form the EUV-transmissive film 116 into a self-supporting film (Figure 4B(g)). Thus, a pellicle 118 having a frame 117 that includes the substrate 110 and mask layer 112 remained in a frame shape, and having the EUV-transmissive film 116 is obtained.

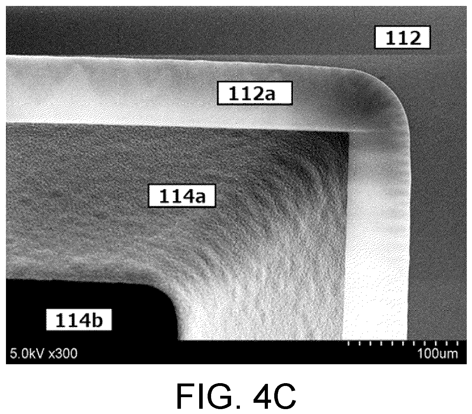

However, in the pellicle 118 thus fabricated, an inner edge part 112a of the mask layer 112 in a frame shape remains in an eave shape extending towards the cavity 114, as illustrated in Figure 4B(g) and Figure 4C. The reason for this is as follows: when the substrate 110 such as a Si wafer is etched from the lower surface to form the cavity 114, the substrate 110 is also side-etched in the horizontal direction, as etching proceeds in the upward direction in the figure. If the mask layer 112 is allowed to remain in an extended state towards the cavity 114 in an eave shape like this, the inner edge part 112a in an eave shape, which is weak in strength, is easily broken to generate particles (dust), and particles easily adhere onto the EUV-transmissive film 116. If particles adhere to the EUV-transmissive film 116, EUV light is shielded by the particle upon exposure, and poor exposure is caused such that the mask pattern is not correctly transferred. On the other hand, although it is possible to remove the mask layer 112 after etching of the substrate 110, the process and cost thereof are generated, and this is also the addition of a process having a high risk of breakage of the self-supporting film since the self-supporting film formation of the EUV-transmissive film 116 has been already completed. Thus, there is a need for a production method that prevents the mask layer 112 from remaining in an eave shape extending from the cavity 114.

The inventors have discovered that by forming an EUV-transmissive film on the surface of the substrate on the cavity side and etching away the substrate from the surface on the opposite side from the cavity to form the EUV-transmissive film into a self-supporting film, it is possible to produce a high-quality EUV-transmissive film or pellicle by an efficient method that prevents the mask layer from remaining in an eave shape extending towards the cavity and thus is less likely to generate particles.

Therefore, an object of the present invention is to produce a high-quality EUV-transmissive film or pellicle by an efficient method that prevents the mask layer from remaining in an eave shape extending towards the cavity and thus is less likely to generate particles.

According to an aspect of the present invention, there is provided a method for producing an EUV-transmissive film, comprising the steps of:
providing a substrate having a first surface and a second surface;
covering, with a mask layer, an entire region of the first surface and a peripheral region other than a cavity region positioned in a center of the second surface;
partially etching away the substrate exposed to the cavity region to form a cavity;
etching away the mask layer covering the first surface;
forming an EUV-transmissive film on a surface of the substrate on the cavity side and on a surface of the mask layer covering the second surface; and
etching away the substrate from the first surface until the EUV-transmissive film is exposed to an opposite side from the cavity to form the EUV-transmissive film in the cavity region into a self-supporting film.

According to another aspect of the present invention, there is provided a method for producing an EUV-transmissive film, comprising the steps of:
providing a substrate having a first surface and a second surface;
covering, with a mask layer, an entire region of the first surface and a peripheral region other than a cavity region positioned in a center of the second surface;
partially etching away the substrate exposed to the cavity region to form a cavity;
etching away the mask layer covering the first surface and the mask layer covering the peripheral region of the second surface;
forming an EUV-transmissive film on a surface of the substrate on the cavity side; and
etching away the substrate from the first surface until the EUV-transmissive film is exposed to an opposite side from the cavity to form the EUV-transmissive film in the cavity region into a self-supporting film.

According to another aspect of the present invention, there is provided a pellicle comprising:
a substrate having a first surface and a second surface, and having a cavity in a center of the substrate;
a mask layer covering the second surface of the substrate; and
an EUV-transmissive film continuously covering a surface of the mask layer and an inner surface of the cavity of the substrate, and being exposed as a self-supporting film constituting a bottom surface of the cavity at the same height as the first surface.

According to another aspect of the present invention, there is provided a pellicle comprising:
a substrate having a first surface and a second surface, and having a cavity in a center of the substrate; and
an EUV-transmissive film continuously covering the second surface of the substrate and an inner surface of the cavity, and being exposed as a self-supporting film constituting a bottom surface of the cavity at the same height as the first surface.

### BRIEF DESCRIPTION OF DRAWINGS

Figure 1A is a diagram of an example of the former steps in the method for producing an EUV-transmissive film according to an aspect of the present invention.
Figure 1B is a diagram of an example of the latter steps in the method for producing an EUV-transmissive film according to an aspect of the present invention, following Figure 1A.
Figure 1C is a diagram of another example of the latter steps in the method for producing an EUV-transmissive film according to an aspect of the present invention, following Figure 1A.
Figure 2A is a diagram of another example of the former steps in the method for producing an EUV-transmissive film according to the present invention.
Figure 2B is a diagram of an example of the latter steps in the method for producing an EUV-transmissive film according to the present invention, following Figure 2A.
Figure 3A is a diagram of an example of the former steps in the method for producing an EUV-transmissive film using a SOI substrate according to the present invention.
Figure 3B is a diagram of an example of the latter steps in the method for producing an EUV-transmissive film using a SOI substrate according to the present invention, following Figure 3A.
Figure 4A is a diagram of the former steps in the method for producing an EUV-transmissive film according to a conventional technique.
Figure 4B is a diagram of the latter steps in the method for producing an EUV-transmissive film according to a conventional technique, following Figure 4A.
Figure 4C is an SEM image obtained by observing a part of the pellicle shown in Figure 4B(g) (the region 4C surrounded by a solid line) from the mask layer side toward the bottom of the cavity.

### DESCRIPTION OF EMBODIMENTS

### Method for producing EUV-transmissive film

The method for producing an EUV-transmissive film according to the present invention includes the steps of (1) provision of a substrate, (2) formation of a mask layer, (3) formation of a cavity, (4) removal of a mask layer, (5) formation of an EUV-transmissive film, and (6) formation of the EUV-transmissive film into a self-supporting film. In the present invention, an EUV-transmissive film is formed on a surface on the cavity side of a substrate, and the substrate is etched away from the surface on the opposite side from the cavity to form the EUV-transmissive film into a self-supporting film. Thus, it is possible to produce a high-quality EUV-transmissive film or pellicle by an efficient method that prevents the mask layer from remaining in an eave shape extending towards the cavity and thus is less likely to generate particles. The details will be clear from the following descriptions.

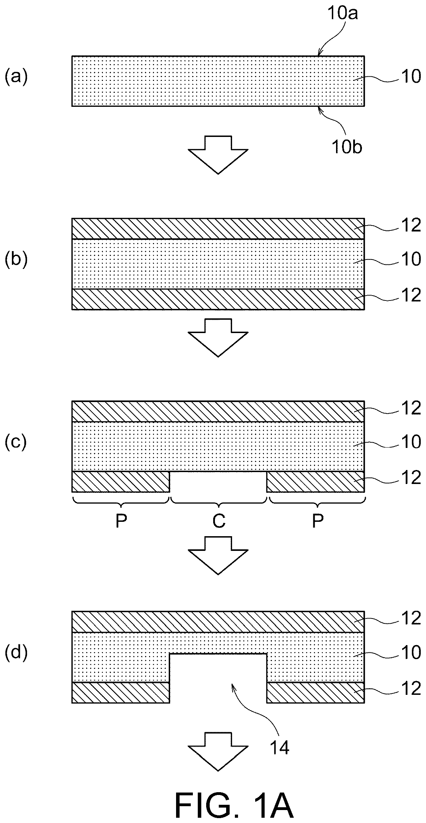

Figures 1A to 4B illustrate methods for producing an EUV-transmissive film according to some aspects of the present invention. Each step will be described below with reference to these drawings.

### (1) Provision of substrate

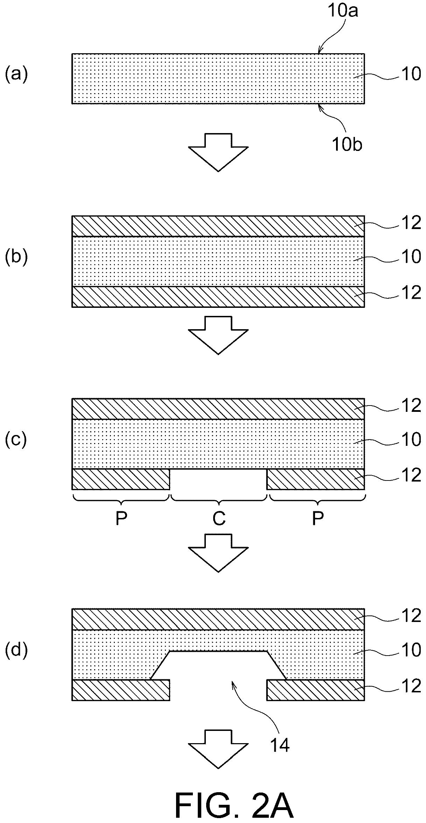

As illustrated in Figure 1A(a) and Figure 2A(a), a substrate 10 is provided. The substrate 10 has a first surface 10a and a second surface 10b. The second surface 10b is the side on which a cavity is formed in the latter step, and the first surface 10a is the side on which a cavity is not formed in the latter step. The substrate 10 is a support for forming an EUV-transmissive film 16 thereon. In the substrate 10, a cavity region C is etched away and a peripheral region P other than the cavity region C remains as a frame, to finally form the EUV-transmissive film 16 into a self-supporting film. Thus, the substrate 10 is desirably a material that gives a desirable base for forming the EUV-transmissive film 16 and can also be etched away. Such a substrate 10 is not particularly limited, and is preferably a Si substrate (e.g., Si wafer).

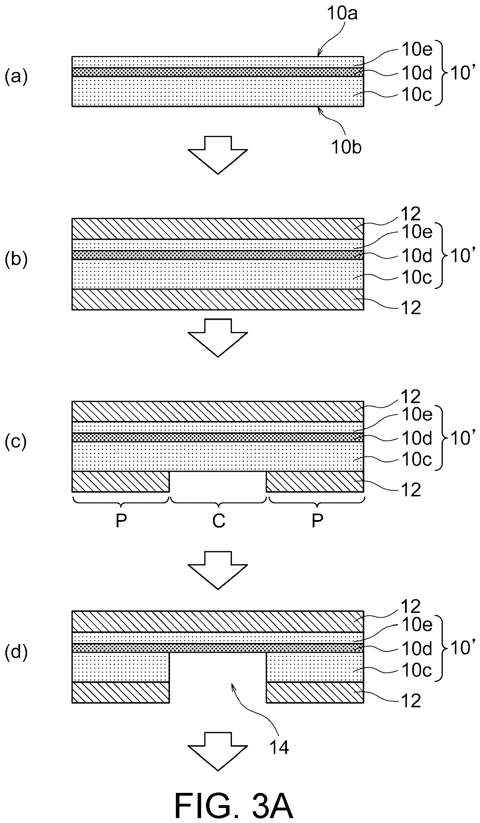

The substrate 10 may be a SOI (Silicon on Insulator) substrate. As illustrated in Figure 3A(a), the SOI substrate 10' is composed of a Si substrate 10c, a SiOz layer 10d, and a Si layer 10e, and the SiOz layer 10d is interposed between the Si substrate 10c and the Si layer 10e. In this case, the first surface 10a is the surface of the Si layer 10e, and the second surface 10b is the surface of the Si substrate 10c. Use of the SOI substrate 10' enables etching to be correctly stopped at the SiOz layer 10d upon etching (Si etching) of the Si substrate 10c. Thus, the SOI substrate 10' has an advantage in that defects due to over-etching of Si (e.g., loosening of the self-supporting film due to too thin a substrate 10) are easily avoided.

### (2) Formation of mask layer

As illustrated in Figures 1A(b) and (c) and Figures 2A(b) and (c), each of the entire region of the first surface 10a and the peripheral region P other than the cavity region C positioned in the center of the second surface 10b on the substrate 10 is covered with a mask layer 12. The mask layer 12 is not particularly limited, as long as it is a material having corrosion resistance to a wet etching solution used in the etching of the substrate 10 (e.g., TMAH used in Si etching). A preferred mask layer 12 is a SiOz film. The mask layer 12 may be formed by any methods. For example, the formation of the SiOz film is preferably carried out by chemical vapor deposition (CVD) or thermal oxidation. The thickness of the SiOz film is preferably from 100 to 1000 nm.

The formation of the mask layer 12 can be carried out as follows. First, the mask layer 12 is formed on each of the first surface 10a and the second surface 10b of the substrate 10 (Figure 1A(b) and Figure 2A(b)). Then, a resist is applied to the first surface 10a and the second surface 10b, and exposure and development are carried out so that an opening of the resist corresponding to the cavity region C is formed on the second surface 10b side to form a resist mask (not shown). The size of the cavity region C corresponds to the size of the EUV-transmissive film 16 to be fabricated. The exposed part of the mask layer 12 at the opening of the resist mask is etched away by wet etching with an etching solution such as hydrofluoric acid, and then, the resist mask is removed. Thus, the mask layer 12 having an opening on the cavity region C is obtained (Figure 1A(c) and Figure 2A(c)).

### (3) Formation of cavity

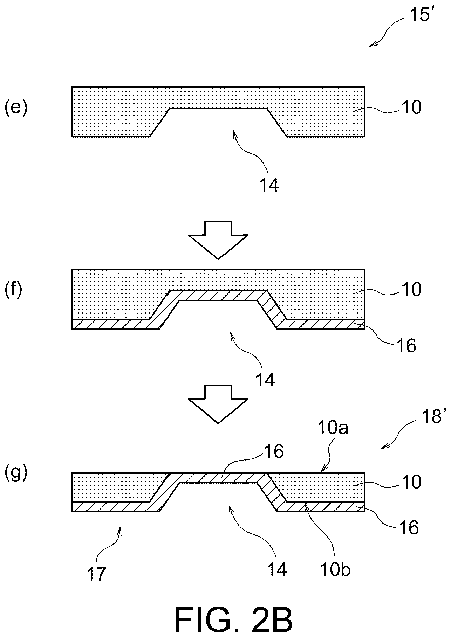

As illustrated in Figure 1A(d) and Figure 2A(d), the substrate 10 exposed to the cavity region C is partially etched away to form a cavity 14. In other words, the cavity region C of the substrate 10 is etched away after the EUV-transmissive film 16 is formed thereon. Thus, to carry out etching efficiency in a short time, the thickness of the substrate 10 of a region on which a self-supporting film is to be formed (that is, the cavity region C) is desired to be made thin in advance. Thus, the cavity region C of the substrate 10 is made thin by etching the substrate 10 from the opening of the mask layer 12 to form the cavity 14. The etching of the substrate 10 may be either wet etching or dry etching, and is not particularly limited. The etchant is not particularly limited, as long as the substrate 10 can be etched therewith. For example, when etching is carried out by the Deep RIE method, which is a dry process, the Si substrate is etched perpendicular to the mask layer 12 as illustrated in Figure 1A(d), so that the mask layer 12 is less likely to remain in an eave shape, which is preferable. When the Si substrate is subjected to wet etching, a TMAH (tetramethyl ammonium hydroxide) solution is preferable. When a TMAH solution is used under appropriate conditions, anisotropic etching to Si can be achieved, resulting in significantly good etching. In particular, upon formation of the cavity 14 by anisotropic etching, the mask layer 12 is less likely to remain in an eave shape since etching can be straightforwardly carried out in the thickness direction of the substrate 10 (less likely to run into immediately below the mask layer 12), and therefore, anisotropic etching can be said to be more advantageous than isotropic etching. Nevertheless, when wet etching is carried out, the Si substrate is etched not only in the perpendicular direction, but also in the horizontal direction due to the running of the solution as in Figure 2A(d), so that the mask layer 12 may temporarily remain in an eave shape. However, in the aspect illustrated in Figures 2A and 2B, the mask layer 12 is removed in the subsequent step as in Figure 2B(e), so that the mask layer 12 can be prevented from remaining in an eave shape.

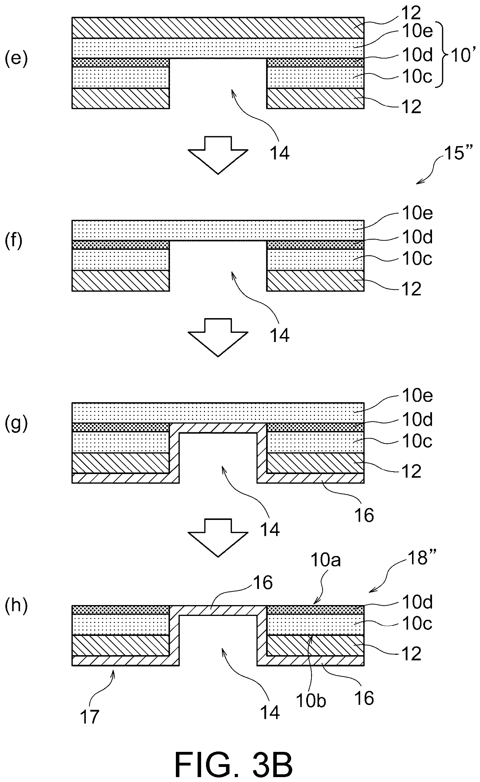

When the SOI substrate 10' is used, as illustrated in Figure 3A(d) and Figure 3B(e), the formation of the cavity 14 is preferably carried out by etching away the Si substrate 10c until the cavity 14 reaches the SiOz layer 10d (Figure 3A(d)), and then separately etching away the SiOz layer 10d from the cavity 14 (Figure 3B(e)). The etching of the Si substrate 10c may be carried out by either dry etching or wet etching, as described above. In this aspect, etching can be correctly stopped at the SiOz layer 10d, so that defects due to over-etching of Si (e.g., loosening of the self-supporting film due to too thin a substrate 10) can be avoided. The etching away of the SiOz layer 10d exposed to the cavity 14, which is subsequently carried out, is preferably carried out with hydrofluoric acid. Thus, the Si layer 10e is exposed as a self-supporting film in the cavity 14.

### (4) Removal of mask layer

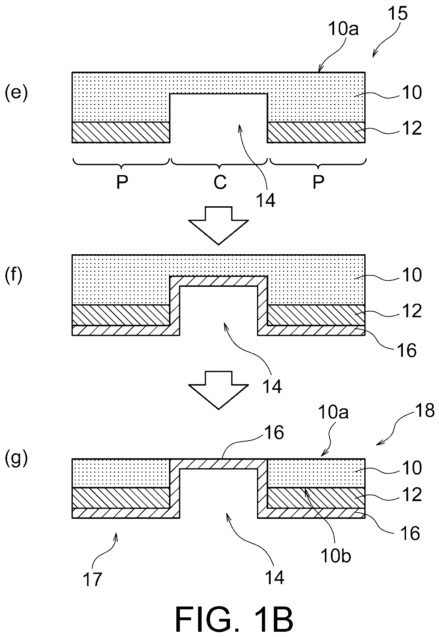

As illustrated in Figure 1B(e), the mask layer 12 that covers the first surface 10a is etched away. Thus, the substrate 10 having the cavity 14 (that is, a cavity substrate 15) is obtained. The etching away of the mask layer 12 is carried out by wet etching using an etching solution such as hydrofluoric acid, as described above. Thus, the cavity substrate 15 having the cavity 14 is obtained. The mask layer 12 that covers the peripheral region P of the second surface 10b is allowed to remain. That is, in the subsequent film formation step, the EUV-transmissive film 16 can be formed over the mask layer 12 that covers the peripheral region P of the second surface 10b. As a result, mask removal process can be omitted.

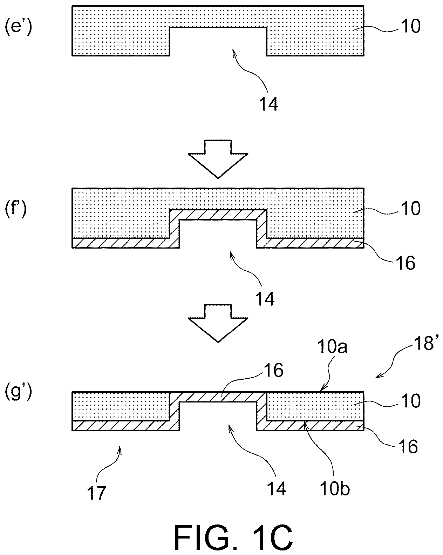

But of course, the mask layer 12 that covers the peripheral region P of the second surface 10b may be etched away, as a variation. That is, as illustrated in Figure 1C(e') and Figure 2B(e), both the mask layer 12 that covers the first surface 10a and the mask layer 12 that covers the peripheral region P of the second surface 10b may be etched away. By etching away the mask layer 12 that covers the peripheral region P of the second surface 10b, no mask layer 12 is present, so that the mask layer 12 can be prevented from remaining in an eave shape.

Also when the SOI substrate 10' is used, the mask layer 12 that covers the first surface 10a may be etched away as above, as illustrated in Figure 3B(f).

### (5) Formation of EUV-transmissive film

As illustrated in Figure 1B(f), the EUV-transmissive film 16 is formed on the surface of the substrate 10 on the cavity 14 side and the surface of the mask layer 12 that covers the second surface 10b. Alternatively, in a variation as illustrated in Figure 1C(f') and Figure 2B(f), the EUV-transmissive film 16 is formed on the surface of the substrate 10 on the cavity 14 side. Specifically, although the formation of the EUV-transmissive film 16 has been carried out on a flat surface on the opposite side from the surface on which the cavity 14 is formed in the conventional method, the film is formed purposely from the non-flat surface side of the substrate 10 on which the cavity 14 is formed (when the mask layer 12 is present, from thereabove) in the present invention. Advantages accompanying this will be mentioned in the description for the next step.

The EUV-transmissive film 16 preferably has a main layer composed of at least one metal selected from the group consisting of Ni, Al, Be, Cr, and Ga. These metals have advantages in that they are less likely to be eroded by XeF₂ gas when the substrate 10 such as a Si substrate is etched away using XeF₂ gas to form the EUV-transmissive film 16 into a self-supporting film. This is supported by the fact that the boiling point of each fluoride of Ni, Al, Be, Cr, and Ga is significantly as high as 1750°C (NiF₂), 1260°C (AlF₃), 1169°C (BeF₂), 1100°C (CrF₂), and 950°C (GaF₃) as compared with the boiling point of XeF₂ of 114°C. A high boiling point indicates a low vapor pressure and it can thus be said that they are less likely to be etched by XeF₂ gas. For the EUV-transmissive film, a particularly preferable main layer is composed of Be (metal beryllium). Be has higher EUV transmittance than Si and C, and thus exhibits a high EUV transmittance (e.g., 93% or more) at a practical level. In addition, the EUV-transmissive film 16 preferably further has a protective layer that covers at least one surface (preferably both surfaces) of the main layer, in view of protecting the main layer. When the main layer is composed of Be, preferred examples of the material constituting the protective layer include beryllium nitride, beryllium oxide, and beryllium fluoride.

The formation of the EUV-transmissive film 16 may be carried out by any film formation methods. Preferred examples of film formation methods include sputtering methods and CVD (chemical vapor deposition). As described above, in the present invention, the film is formed from the non-flat surface side of the substrate 10 on which the cavity 14 is formed. Even when using a film formation method that is inferior in step coverage, such as sputtering, there is no great difference in film thickness on the inner surface of the cavity 14, from that in the case of forming a film on a flat surface, because the substrate 10 such as a Si substrate usually has a thickness of 1 mm or less.

For example, when a three-layer structure of beryllium nitride/beryllium/beryllium nitride is fabricated, the beryllium film as the main layer is preferably fabricated by sputtering using a pure Be target, and the beryllium nitride film as the protective layer is preferably formed by reactive sputtering. The reactive sputtering can be carried out by, for example, introducing nitrogen gas into a chamber during sputtering using a pure Be target, and thereby reacting beryllium and nitrogen to produce beryllium nitride. As described below, the beryllium nitride film may have a gradient composition layer (a layer composed of a nitrogen concentration gradient region described below) in which the nitrogen concentration decreases towards the beryllium film. An example of a preferred procedure in this case is as follows. First, Be sputtering is carried out while introducing nitrogen gas in addition to Ar that is usually used as the atmosphere gas to form a film of beryllium nitride. After a beryllium nitride film having a predetermined thickness is formed, Be sputtering is carried out while reducing the amount of nitrogen gas to form a gradient composition layer. After the gradient composition layer is formed, subsequent introduction of nitrogen gas is stopped, and a beryllium layer is formed to have a predetermined thickness. Thereafter, while increasing the amount of nitrogen gas to be introduced, a gradient composition layer is formed again, and a beryllium nitride film is formed again by reactive sputtering as the outermost layer.

As another method, beryllium nitride can be fabricated as follows: a beryllium film is formed and then irradiated with nitrogen plasma to subject beryllium to a nitriding reaction, thereby producing beryllium nitride. Anyway, the synthesis method of beryllium nitride is not limited thereto. As for the beryllium target for forming a beryllium nitride film and the beryllium target for forming a beryllium film, different targets are preferably used, but it is possible to use the same target for the beryllium nitride film formation and the beryllium film formation. The beryllium nitride film and the beryllium film may be formed in a single-chamber sputtering apparatus as in Examples described below, or the beryllium nitride film and the beryllium film may be formed in separate chambers using a two-chamber sputtering apparatus.

Also when the SOI substrate 10' is used, the EUV-transmissive film 16 may be formed on the surface on the cavity 14 side of the SOI substrate 10' and the surface of the mask layer 12 covering the second surface 10b in the same manner as above, as illustrated in Figure 3B(g).

### (6) Formation of EUV-transmissive film into self-supporting film

As illustrated in Figure 1B(g), Figure 1C(g'), and Figure 2B(g), the substrate 10 is etched away from the first surface 10a until the EUV-transmissive film 16 is exposed to the opposite side from the cavity 14 to form the EUV-transmissive film 16 at the cavity region C into a self-supporting film. Thus, the etching of the substrate 10 (e.g., Si substrate) to form the EUV-transmissive film 16 into a self-supporting film is carried out from the flat surface of the substrate 10 on the opposite side from the cavity 14, unlike the conventional process, in which the etching of the substrate 10 is carried out from the inner surface of the cavity 14. This provides some advantages below.

First, since the EUV-transmissive film 16 has a resistance to the etchant (or has a protective film having a resistance to the etchant), it functions as a protective film on the cavity 14 surface of the substrate 10 such as a Si substrate, and prevents the inner surface of the cavity 14 of the substrate 10 from being side-etched. Thus, the mask layer 12 can be prevented from remaining in an eave shape. Specifically, as described above, a problem with the conventional process is that side etching occurs at the side surface of the cavity 14, and that as a result, the mask layer 112 remains in an eave shape extending towards the cavity 114, as illustrated in Figure 4B(g) and Figure 4C. In this state, the inner edge part 112a in an eave shape, which is weak in strength, is easily broken to generate particles (dust) and particles are easily adhered onto the EUV-transmissive film 116. If particles adhere to the EUV-transmissive film 116, EUV light is shielded by the particle upon exposure, and poor exposure is caused such that the mask pattern is not correctly transferred. In contrast, the cavity 14 and the mask layer 12 are coated with the EUV-transmissive film 16 in the method of the present invention, and accordingly, no side etching occurs, so that the mask layer 12 can be prevented from remaining in an eave shape. Although it is possible to remove the mask layer 12 after etching of the substrate 10, the process and cost therefor are generated, and this is also the addition of a process having a high risk of breakage of the self-supporting film since the self-supporting film formation of the EUV-transmissive film 16 has been already completed. In the method of the present invention, addition of such a process is unnecessary.

Second, since the etching of the substrate 10 proceeds on a flat surface having no cavity 14, uneven etching due to the difference in shape between the flat part and the non-flat part (such as the corner part) is less likely to occur as compared with etching from the surface of the substrate 10 on the cavity 14 side, thus enabling uniform etching. Specifically, whereas uneven etching partially occurs due to uneven diffusion of the etchant and the like in the etching from the inner surface of the cavity 14 in the conventional process, uneven etching is less likely to occur in the method of the present invention since the EUV-transmissive film 16 can be formed into a self-supporting film by etching of the flat surface. Thus, according to the method of the present invention, a high-quality EUV-transmissive film 16 or pellicle 18 can be produced.

Thus, according to the method of the present invention, a high-quality EUV-transmissive film or pellicle can be produced by an efficient method that prevents the mask layer 12 from remaining in an eave shape extending towards the cavity 14 and thus is less likely to generate particles.

Etching of the substrate 10 to form the EUV-transmissive film 16 into a self-supporting film is preferably carried out by etching that does not erode the EUV-transmissive film 16. For example, when etching of the Si substrate is carried out, etching is preferably carried out by XeF₂ gas.

Also when the SOI substrate 10' is used, the formation of the EUV-transmissive film 16 into a self-supporting film may be carried out by etching away the SOI substrate 10' (specifically, the Si layer 10e) from the first surface 10a until the EUV-transmissive film 16 is exposed to the opposite side from the cavity 14, as illustrated in Figure 3B(h). Thus, as a result of forming the EUV-transmissive film 16 at the cavity region C into a self-supporting film, the self-supporting film part of the EUV-transmissive film 16 and the SiOz layer 10d are exposed on the same plane on the opposite side from the cavity 14. In the present aspect, the SiOz layer 10d is present below the Si layer 10e. Thus, even when etching time management to remove the Si layer 10e in XeF₂ etching is not strictly carried out, etching can be stopped at the SiOz layer 10d.

Thus, as a result of etching away the substrate 10 or the SOI substrate 10', the EUV-transmissive film 16 at the cavity region C is formed into a self-supporting film. On the other hand, three layers of the substrate 10, the mask layer 12, and the EUV-transmissive film 16 (Figure 1B(g)), two layers of the substrate 10 and the EUV-transmissive film 16 (Figure 1C(g') and Figure 2B(g)), or four layers of the SiOz layer 10d, the Si substrate 10c, the mask layer 12, and the EUV-transmissive film 16 (Figure 3B(h)) remain at the peripheral region P other than the cavity region, and forms a frame 17 for supporting the self-supporting film. Consequently, the pellicle 18 having the EUV-transmissive film 16 (pellicle film) and the frame 17 can be obtained.

### Pellicle

As described above, according to the production method of the present invention, an EUV-transmissive film and a pellicle including the EUV-transmissive film are produced.

As illustrated in Figure 1B(g), the pellicle 18 according to an aspect of the present invention includes the substrate 10, the mask layer 12, and the EUV-transmissive film 16. The substrate 10 has the first surface 10a and the second surface 10b, and the cavity 14 in the center of the substrate 10. The mask layer 12 covers the second surface 10b of the substrate 10. The EUV-transmissive film 16 continuously covers the surface of the mask layer 12 and the inner surface of the cavity 14 of the substrate 10, and is exposed as a self-supporting film constituting the bottom surface of the cavity 14 at the same height as the first surface 10a.

As illustrated inFigure 1C(g') and Figure 2B(g), the pellicle 18' according to another aspect of the present invention includes the substrate 10 and the EUV-transmissive film 16. The substrate 10 has the first surface 10a and the second surface 10b, and the cavity 14 in the center of the substrate 10. The EUV-transmissive film 16 continuously covers the second surface 10b of the substrate 10 and the inner surface of the cavity 14, and is exposed as a self-supporting film constituting the bottom surface of the cavity 14 at the same height as the first surface 10a.

In each aspect, as the pellicle 18" illustrated in Figure 3B(h), the substrate 10 may be composed of two layers of the Si substrate 10c and the SiOz layer 10d. This is a typical layer structure of the pellicle 18" produced by using the SOI substrate 10'.

As described above, the pellicle 18, 18', or 18" has the EUV-transmissive film 16 (pellicle film) and the frame 17. The frame 17 is composed of three layers of the substrate 10, the mask layer 12, and the EUV-transmissive film 16 (Figure 1B(g)), two layers of the substrate 10 and the EUV-transmissive film 16 (Figure 1C(g') and Figure 2B(g)), or three or four layers of the SiOz layer 10d, the Si substrate 10c, the mask layer 12 (optional), and the EUV-transmissive film 16 (Figure 3B(h)).

### Preferred aspect of EUV-transmissive film

As described above, the EUV-transmissive film according to a preferred aspect includes a main layer, and a protective layer covering at least one surface (preferably both surfaces) of the main layer. In the present aspect, the main layer is preferably composed of metal beryllium, whereas the protective layer is preferably composed of beryllium nitride. Thus, by combining the main layer composed of metal beryllium and the protective layer composed of beryllium nitride, there can be provided an EUV-transmissive film having a high EUV transmittance (e.g., 93% or more) at a practical level and the durability in a low pressure hydrogen atmosphere environment.

The main layer according to the present aspect is preferably composed of metal beryllium. But of course, the main layer does not necessarily completely consist of metal beryllium, and metal beryllium preferably accounts for 99 wt% or more, more preferably 99.5 wt% or more, and further preferably 99.8 wt% or more of the main layer. This main layer contributes to the achievement of a high EUV transmittance at a practical level while ensuring the basic function as a pellicle film (for example, the effect of preventing adhesion of particles). From such a viewpoint, the thickness of the main layer is preferably from 10 to 70 nm, more preferably from 15 to 50 nm, and further preferably from 20 to 35 nm.

The protective layer in the present aspect is a layer for protecting the main layer as the metal beryllium layer. Thus, the protective layer may cover at least one surface of the main layer, and both surfaces of the main layer are preferably covered with protective layers. The protective layer is preferably composed of beryllium nitride. But of course, the main layer does not necessarily completely consist of beryllium nitride, and beryllium nitride preferably accounts for 99 wt% or more, preferably 99.5 wt% or more, and further preferably 99.8 wt% or more of the main layer. Beryllium nitride has a high EUV transmittance, and thus, the EUV transmittance is higher than that of the beryllium film with a Ru layer formed thereon, when comparing them in the same thickness conditions. According to a theoretical calculation, the transmittance when a Ru film having a thickness of 3 nm is formed on both surfaces of a beryllium film having a thickness of 30 nm is 85.8%, whereas the transmittance when a beryllium nitride having a thickness of 3 nm is formed on both surfaces of the beryllium film having a thickness of 30 nm is 91.1%. The transmittance when beryllium nitride having a thickness of 2 nm and a gradient composition layer (a layer composed of the nitrogen concentration gradient region described below) having a thickness of 1 nm are formed on both surfaces of the beryllium film having a thickness of 30 nm is more than 91.1%. Forming a tight beryllium nitride layer on both surfaces of the beryllium layer can suppress the reaction with the XeF₂ gas used in the etching of the Si substrate described below. Although beryllium, which is a material having a significantly high reactivity, is easily oxidized to form beryllium oxide, the formation of beryllium nitride can suppress oxidation. As described above, the advantages of using the beryllium nitride layer as the protective layer are the enhancement of the EUV transmittance, the protection of the beryllium film (the main layer) in the etching process, and oxidation prevention.

The thickness of the protective layer according to the present aspect is preferably 5 nm or less, and more preferably 3 nm or less. Considering forming a protective layer having a thickness of 3 nm on both surfaces of the main layer, the EUV transmittance with the beryllium nitride film having a thickness of 3 nm is 95%, which is significantly higher than that with the Ru film of 90%. The lower limit value of the thickness of the protective layer is not particularly limited, and the thickness is typically 1 nm or more. In the case of too thin a protective layer, it may be difficult to coat the entire surface of the main layer, or the crystallinity of beryllium nitride may be poor so that physical properties as beryllium nitride may be less likely to be obtained. As used herein, the term "beryllium nitride" means a comprehensive composition that allows not only a stoichiometric composition such as Be₃N₂, but also a non-stoichiometric composition such as Be₃N₂₋ₓ, wherein 0 < x < 2.

The protective layer preferably has a nitrogen concentration gradient region in which the nitrogen concentration decreases toward the main layer. Specifically, as described above, the composition of beryllium nitride constituting the protective layer encompasses not only a stoichiometric composition such as Be₃N₂, but also a non-stoichiometric composition such as Be₃N₂₋ₓ, wherein 0 < x < 2, and the beryllium nitride constituting the protective layer preferably has a gradient composition in which beryllium nitride has an increasingly beryllium-rich composition toward the main layer. Thus, the adhesiveness between the protective layer (that is, beryllium nitride layer) and the main layer (that is, metal beryllium layer) can be improved, and the generation of the stress due to the thermal expansion difference between both layers can be moderated. Specifically, the nitrogen concentration gradient region can improve the adhesiveness between both layers to prevent peeling, and also serves as a thermal expansion moderating layer between both layers when the layers absorb the EUV light to be heated to a high temperature, thereby less likely to cause peeling. The thickness of the nitrogen concentration gradient region is preferably smaller than the thickness of the protective layer. In other words, the whole of the thickness of the protective layer is not necessarily the nitrogen concentration gradient region. For example, only a part of the thickness of the protective layer, for example, preferably a region from 10 to 70%, and more preferably from 15 to 50% of the thickness of the protective layer is preferably the nitrogen concentration gradient region.

The EUV-transmissive film 16 according to the present aspect can have a high EUV transmittance at a practical level, and preferably has an EUV transmittance of 91% or more, more preferably 92% or more, and further preferably 93% or more. The higher the EUV transmittance, the more desirable it is. Thus, the upper limit value is not particularly limited, and the EUV transmittance of the EUV-transmissive film 16 according to the present aspect may be typically 99% or less, more typically 98% or less, and further typically 95% or less.

### EXAMPLES

The present invention will be further specifically described by way of the following examples.

### Example 1

A composite self-supporting film (EUV-transmissive film) having a three-layer structure of beryllium nitride/beryllium/beryllium nitride was fabricated according to the procedure illustrated in Figures 1A and 1B as follows.

### (1) Provision of cavity substrate

A Si wafer having a diameter of 8 inches (20.32 cm) was provided as the substrate 10 (Figure 1A(a)). On both surfaces of the Si wafer, a SiOz layer having a thickness of 1 µm was formed as the mask layer 12 by thermal oxidation (Figure 1A(b)). A resist was applied to both surfaces of the Si wafer on which the SiOz layer was formed, and exposure and development were carried out so that a hole of a resist with 110 mm × 140 mm was formed on one surface as the cavity region C to form a resist mask for SiOz etching (not shown). By subjecting this surface of the substrate to wet etching with hydrofluoric acid, the exposed part of the SiOz film in the cavity region C was etched away to expose the Si wafer, and then the resist mask was removed by an ashing apparatus (Figure 1A(c)). Thereafter, the Si wafer was subjected to dry etching (anisotropic etching) by reactive ion etching from the exposed part of the cavity region C in the thickness direction to form the cavity 14 (Figure 1A(d)). At this time, the etching time was calculated from the etching rate in advance so that the thickness of the Si wafer remained as the bottom of the cavity 14 was about 10 µm, and etching was carried out for the etching time. The SiOz layer on the surface on the opposite side from the cavity 14 was removed and cleaned with hydrofluoric acid to provide the cavity substrate 15 for forming an EUV-transmissive film (Figure 1B(e)).

### (2) Formation of composite film

On the cavity 14 forming surface of the cavity substrate 15 obtained in the above (1), a composite film having a three-layer structure of beryllium nitride/beryllium/beryllium nitride was formed over the entire region including not only the cavity region C (the inner surface of the cavity 14) but also the peripheral region P (SiOz layer) as follows (Figure 1B(f)). First, the cavity substrate 15 was set to a sputtering apparatus, and a pure Be target was mounted. The inside of the chamber was evacuated, reactive sputtering was carried out by adjusting the internal pressure to 0.5 Pa and the flow rate ratio of argon gas to nitrogen gas to 1:1, and reactive sputtering was terminated at the time when beryllium nitride was deposited to a thickness of 2 nm. Then, sputtering was carried out only using argon gas without introducing nitrogen gas, and sputtering was terminated at the time when beryllium was deposited to a thickness of 25 nm. Thereafter, reactive sputtering was carried out while introducing nitrogen gas again in the same manner as the first time, and reactive sputtering was terminated at the time when beryllium nitride was deposited to a thickness of 2 nm. Thus, a composite film of beryllium nitride 2 nm/beryllium 25 nm/beryllium nitride 2 nm was formed as the EUV-transmissive film 16.

### (3) Formation into self-supporting film

The cavity substrate 15 with the EUV-transmissive film 16 obtained in the above (2) was set in a chamber of a XeF₂ etcher so that the surface on the opposite side from the cavity 14 (that is, the exposed surface of the Si substrate 10) was to be subjected to XeF₂ etching, and the inside of the chamber was sufficiently evacuated. At this time, if the moisture remains in the chamber, it reacts with XeF₂ gas to generate hydrofluoric acid, causing corrosion of the etcher or unexpected etching. Thus, sufficient evacuation was carried out. Evacuation of the inside of the chamber and introduction of nitrogen gas were repeated as necessary, and the remaining moisture was reduced. After sufficient evacuation was achieved, a valve between a XeF₂ raw material cylinder and a preliminary chamber was opened. As a result, XeF₂ was sublimated and XeF₂ gas was accumulated also in the preliminary chamber. After XeF₂ gas was sufficiently accumulated in the preliminary chamber, a valve between the preliminary chamber and the chamber was opened, and XeF₂ gas was introduced into the chamber. XeF₂ gas was reacted with Si to produce SiF₄ and Xe. Since the boiling point of SiF₄ was -95°C, the produced SiF₄ was rapidly evaporated, and the reaction between the newly exposed Si substrate and F was caused. After XeF₂ in the chamber was reduced due to the proceeding of Si etching, the inside of the chamber was evacuated, XeF₂ gas was introduced into the chamber again, and etching was carried out. Thus, evacuation, XeF₂ gas introduction, and etching were repeated, and etching was continued until the Si substrate 10 corresponding to the part to be formed into a self-supporting film was eliminated. When the Si substrate of the unnecessary part was eliminated, etching was terminated. Consequently, the pellicle 18 having a composite self-supporting film of the EUV-transmissive film 16 and the frame 17 supporting the composite self-supporting film was obtained (Figure 1B(g)). The EUV transmittance of the obtained composite self-supporting film having a three-layer structure of beryllium nitride/beryllium/beryllium nitride was measured and found to be 92.8%.

### Example 2

A composite self-supporting film (EUV-transmissive film) having a three-layer structure of beryllium nitride/beryllium/beryllium nitride was fabricated according to the procedure illustrated in Figure 2A and Figure 2B as follows.

### (1) Provision of cavity substrate

A Si wafer having a diameter of 8 inches (20.32 cm) was provided as the substrate 10 (Figure 2A(a)). On both surfaces of the Si wafer, a SiOz layer having a thickness of 1 µm was formed as the mask layer 12 by thermal oxidation (Figure 2A(b)). A resist was applied to both surfaces of the Si wafer on which the SiOz layer was formed, and exposure and development were carried out so that a hole of a resist with 110 mm × 140 mm was formed on one surface as the cavity region C to form a resist mask for SiOz etching (not shown). By subjecting this surface of the substrate to wet etching with hydrofluoric acid, the exposed part of the SiOz film in the cavity region C was etched away to expose the Si wafer, and then the resist mask was removed by an ashing apparatus (Figure 2A(c)). Thereafter, the Si wafer was subjected to wet etching (anisotropic etching) with a TMAH solution from the exposed part of the cavity region C in the thickness direction to form the cavity 14 (Figure 2A(d)). At this time, the etching time was calculated from the etching rate in advance so that the thickness of the Si wafer remained as the bottom of the cavity 14 was about 10 µm, and etching was carried out for the etching time. At this time, etching with the TMAH solution is anisotropic etching and mainly proceeds in the upward direction in the figure, and etching also proceeds in the horizontal direction. Thus, the mask layer 12 forms an eave shape as in Figure 2A(d). Then, the mask layers 12 on both surfaces of the substrate were removed and cleaned with hydrofluoric acid to provide the cavity substrate 15' for forming an EUV-transmissive film (Figure 2B(e)).

### (2) Formation of composite film

On the cavity 14 forming surface of the cavity substrate 15' obtained in the above (1), a composite film having a three-layer structure of beryllium nitride/beryllium/beryllium nitride was formed over the entire region including not only the cavity region C (the inner surface of the cavity 14) but also the peripheral region P as the EUV-transmissive film 16 in the same manner as in Example 1 (Figure 2B(f)).

### (3) Formation into self-supporting film

The cavity substrate 15' with the EUV-transmissive film 16 obtained in the above (2) was set in a chamber of a XeF₂ etcher so that the surface on the opposite side from the cavity 14 (that is, the exposed surface of the Si substrate 10) was to be subjected to XeF₂ etching, and subject to XeF₂ etching in the same manner as in Example 1. Consequently, by etching away the Si substrate 10 on the bottom of the cavity 14, the pellicle 18' having a composite self-supporting film of the EUV-transmissive film 16 and the frame 17 supporting the composite self-supporting film was obtained (Figure 2B(g)). At this time, unlike Example 1, the mask layer 12 is removed in Example 2, so that an eave structure due to the mask layer 12 is not formed, and the mask layer 12 is not broken and generates no particles. The EUV transmittance of the obtained composite self-supporting film having a three-layer structure of beryllium nitride/beryllium/beryllium nitride was measured and found to be 93.1%.

### Example 3

A composite self-supporting film (EUV-transmissive film) having a three-layer structure of beryllium nitride/beryllium/beryllium nitride was fabricated according to the procedure illustrated in Figures 3A and 3B as follows.

### (1) Provision of cavity substrate

As the substrate 10', a SOI substrate in which the SiOz layer 10d (insulator layer) having a thickness of 1 µm and the Si layer 10e (SOI layer) having a thickness of 10 µm was formed on the Si substrate 10c in the order presented was provided (Figure 3A(a)). On both surfaces of the SOI substrate 10', a SiOz layer having a thickness of 1 µm was formed as the mask layer 12 by thermal oxidation (Figure 3A(b)). A resist was applied to both surfaces of the SOI substrate 10' on which the SiOz layer was formed, and exposure and development were carried out so that a hole of a resist with 110 mm × 140 mm was formed on one surface as the cavity region C to form a resist mask for SiOz etching (not shown). By subjecting this surface of the substrate to wet etching with hydrofluoric acid, the exposed part of the SiOz film in the cavity region C was etched away to expose the SOI substrate 10', and then the resist mask was removed by an ashing apparatus (Figure 3A(c)). Thereafter, the Si substrate 10c was subjected to dry etching (anisotropic etching) by reactive ion etching from the exposed part of the cavity region C in the thickness direction until the SiOz layer 10d was exposed, thereby forming the cavity 14 (Figure 3A(d)). The exposed SiOz layer 10d was etched away with hydrofluoric acid to expose the Si layer 10e (Figure 3B(e)). Thereafter, the mask layer 12 (SiOz layer) on the surface on the opposite side from the cavity 14 was etched away with hydrofluoric acid to provide the cavity substrate 15" for forming an EUV-transmissive film (Figure 3B(f)).

### (2) Formation of composite film

On the cavity 14 forming surface of the cavity substrate 15" obtained in the above (1), a composite film having a three-layer structure of beryllium nitride/beryllium/beryllium nitride was formed over the entire region including not only the cavity region C (the inner surface of the cavity 14) but also the peripheral region P (SiOz layer) as the EUV-transmissive film 16 in the same manner as in Example 1 (Figure 3B(g)).

### (3) Formation into self-supporting film

The cavity substrate 15" with the EUV-transmissive film 16 obtained in the above (2) was set in a chamber of a XeF₂ etcher so that the surface on the opposite side from the cavity 14 (that is, the exposed surface of the Si layer 10e) was to be subjected to XeF₂ etching, and subject to XeF₂ etching in the same manner as in Example 1. Consequently, by etching away the Si layer 10e on the bottom of the cavity 14, the pellicle 18" having a composite self-supporting film of the EUV-transmissive film 16 and the frame 17 supporting the composite self-supporting film was obtained (Figure 3B(h)). At this time, unlike Example 1, the SiOz layer 10d is present below the Si layer 10e in Example 2. Thus, even when etching time management to remove the Si layer 10e in XeF₂ etching is not strictly carried out, etching can be stopped at the SiOz layer 10d. This is advantageous in terms of allowing excess etching to be prevented. The EUV transmittance of the obtained composite self-supporting film having a three-layer structure of beryllium nitride/beryllium/beryllium nitride was measured and found to be 93.3%.

### Results and consideration

In Examples 1 to 3, since both the mask layer for forming a cavity on a substrate (the SiOz layer in Examples 1 to 3) and the inner surface of the cavity are coated with a composite film of beryllium nitride/beryllium/beryllium nitride, the inner surface of the cavity is not etched by XeF₂ etching. That is, no side etching occurs. Since the Si thickness of the bottom of the cavity is 10 µm in Examples 1 to 3, side etching occurs about 10 µm in the conventional method and the mask layer has an eave structure extending towards the cavity. If the mask layer has an eave structure, the mask layer has low strength and is easily broken because it is composed of SiOz having a thickness of only 1 µm. Then, if the mask layer is broken, particles (dust) are generated and adhere onto the self-supporting film. When the self-supporting film is used as a pellicle film, particles adhering onto the self-supporting film cause EUV light to be shielded upon exposure at the particle part, so that the mask pattern is not correctly transferred and poor exposure is caused. In this regard, no eave structure is formed in the self-supporting film fabricated in the present invention, so that the problem of the adhesion of the broken eave structure to the self-supporting film is not caused.

## Claims

1. A method for producing an EUV-transmissive film, comprising the steps of:
providing a substrate having a first surface and a second surface;
covering, with a mask layer, an entire region of the first surface and a peripheral region other than a cavity region positioned in a center of the second surface;
partially etching away the substrate exposed to the cavity region to form a cavity;
etching away the mask layer covering the first surface;
forming an EUV-transmissive film on a surface of the substrate on the cavity side and on a surface of the mask layer covering the second surface; and
etching away the substrate from the first surface until the EUV-transmissive film is exposed to an opposite side from the cavity to form the EUV-transmissive film in the cavity region into a self-supporting film.

2. A method for producing an EUV-transmissive film, comprising the steps of:
providing a substrate having a first surface and a second surface;
covering, with a mask layer, an entire region of the first surface and a peripheral region other than a cavity region positioned in a center of the second surface;
partially etching away the substrate exposed to the cavity region to form a cavity;
etching away the mask layer covering the first surface and the mask layer covering the peripheral region of the second surface;
forming an EUV-transmissive film on a surface of the substrate on the cavity side; and
etching away the substrate from the first surface until the EUV-transmissive film is exposed to an opposite side from the cavity to form the EUV-transmissive film in the cavity region into a self-supporting film.

3. The method for producing an EUV-transmissive film according to claim 1 or 2, wherein the EUV-transmissive film comprises a main layer composed of metal beryllium.

4. The method for producing an EUV-transmissive film according to claim 3, wherein the EUV-transmissive film comprises a protective layer covering at least one surface of the main layer.

5. The method for producing an EUV-transmissive film according to any one of claims 1 to 4, wherein the substrate is a Si substrate.

6. The method for producing an EUV-transmissive film according to any one of claims 1 to 4, wherein the substrate is a SOI substrate, wherein the SOI substrate is composed of a Si substrate, a Si layer, and a SiOz layer interposed between the Si substrate and the Si layer, wherein the first surface is a surface of the Si layer, and wherein the second surface is a surface of the Si substrate.

7. The method for producing an EUV-transmissive film according to claim 6, wherein the cavity is formed by etching away the Si substrate until the cavity reaches the SiOz layer, and then separately etching away the SiOz layer from the cavity, such that a self-supporting film part of the EUV-transmissive film and the SiOz layer are exposed to the same plane on the opposite side from the cavity.

8. A pellicle comprising:
a substrate having a first surface and a second surface, and having a cavity in a center of the substrate;
a mask layer covering the second surface of the substrate; and
an EUV-transmissive film continuously covering a surface of the mask layer and an inner surface of the cavity of the substrate, and being exposed as a self-supporting film constituting a bottom surface of the cavity at the same height as the first surface.

9. A pellicle comprising:
a substrate having a first surface and a second surface, and having a cavity in a center of the substrate; and
an EUV-transmissive film continuously covering the second surface of the substrate and an inner surface of the cavity, and being exposed as a self-supporting film constituting a bottom surface of the cavity at the same height as the first surface.

10. The pellicle according to claim 8, wherein the pellicle is produced by the method according to any one of claims 1 to 7.

11. The pellicle according to claim 9, wherein the pellicle is produced by the method according to any one of claims 2 to 7.
